(19) Europäisches Patentamt
European Patent Office
Office européen des brevets

(11) EP 2 299 487 A2

(12) **EUROPEAN PATENT APPLICATION**

(43) Date of publication:
**23.03.2011 Bulletin 2011/12**

(21) Application number: **10176803.4**

(22) Date of filing: **15.09.2010**

(51) Int Cl.:
***H01L 23/28*** *(2006.01)* ***H01L 31/0216*** *(2006.01)*
***H01L 31/048*** *(2006.01)* ***H01L 51/44*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **16.09.2009 JP 2009214354**

(71) Applicant: **Fujifilm Corporation**
**Minato-ku**
**Tokyo 106-0031 (JP)**

(72) Inventors:
- **Sawada, Makoto**
**Kanagawa 258-8577 (JP)**
- **Hara, Minako**
**Kanagawa 258-8577 (JP)**

(74) Representative: **HOFFMANN EITLE**
**Patent- und Rechtsanwälte**
**Arabellastraße 4**
**81925 München (DE)**

(54) **Protective film and front sheet for solar cell**

(57) The object of the invention is to provide a protective film which comprises a plastic film and a coating layer and which has high transparency, high ultraviolet absorption ability, high weatherability and flexibility. The coating layer comprises a siloxane series binder and cerium oxide particles having an average particle size of 50 nm or less.

Fig. 1

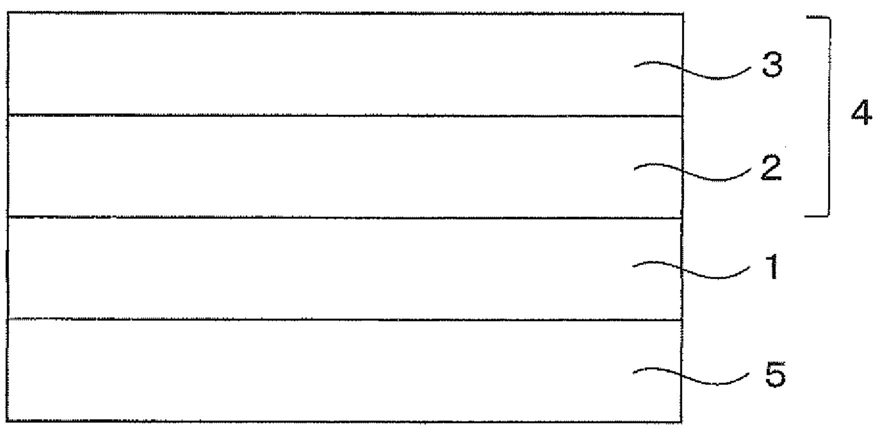


EP 2 299 487 A2

## Description

FIELD OF THE INVENTION

The invention relates to a protective film used for protecting various devices. Particularly, the invention relates to a protective film used for protecting a flexible solar cell and a front sheet used for a solar cell using the protective film.

BACKGROUND OF THE INVENTION

In recent years, a flexible solar cell has been being developed. Such a flexible solar cell requires an ultraviolet absorbable protective film because polyester material such as a gas barrier film which is used as a member composing the solar cell and an active layer itself in an organic solar cell absorb ultraviolet to thereby deteriorate. Since such a solar cell is placed in outside over long years, the protective film is also required to have high weatherability. Furthermore, the protective film is required to have high transparency because the solar cell absorbs sunlight energy and converts the sunlight into electrical power. Therefore, the protective film used for protecting the flexible solar cell is required to have high transparency, high ultraviolet absorption ability, high weatherability and flexibility.

JP-A-2006-255927 discloses, as a protective film for a solar cell, a transparent protective film comprising an organic ultraviolet absorber such as benzotriazole series compounds. Since the protective film comprises an organic material as base material, the protective film is excellent in transparency and flexibility, but is poor in weatherability.

JP-A-2004-168057 discloses, as a protective film for a solar cell, a film which is obtained by laminating, on a surface of a transparent fluorine series film, an acryl series film having a higher refraction index than that of the transparent fluorine series film, and then coating, on the surface of the acryl series film, a coating mixture comprising a siloxane series binder and zinc oxide as an inorganic ultraviolet absorber. JP-A-2004-168057 also discloses that the conversion efficiency is enhanced by enhancing its light diffusion ratio by using zinc oxide having a diameter of around 0.3 μm, which is relatively large, as an inorganic series ultraviolet absorber. However, the film obtainable by using such a technique disclosed in JP-A-2004-168057 is high in haze, so that it is poor in transparency.

Although JP-A-2000-334373 does not relate to a protective film for a solar cell, it discloses a technique to form a coating layer excellent in weatherability by adding, into a siloxane series binder, a zinc oxide particle having a diameter of around 40 nm, which is relatively small. JP-A-2000-334373 also suggests the possibility that transparency is enhanced by using a zinc oxide particle having a smaller diameter. However, the film obtained in JP-A-2000-334373 has a haze value of around 10%, that is, the film cannot be necessarily high in transparency.

On the other hand, JP-A-2002-371234 discloses a under coating composition comprising a complex compound of siloxane and cerium.

SUMMARY OF THE INVENTION

As mentioned above, the protective film for a solar cell or the like is required to have high transparency, high ultraviolet absorption ability, high weatherability and flexibility, however, such a protective film had not been obtained. The inventors further have investigated and found that, when the coating layer disclosed in JP-A-2000-334373 is deposited on the surface of a plastic film, and then, irradiated with ultraviolet, the coating layer is peeled from the plastic film. The inventors further have investigated and found that the under coating composition disclosed in JP-A-2002-371234 is poor in adhesion after ultraviolet exposure. Thus, the under coating composition disclosed in JP-A-2002-371234 is not suitable for protecting a solar cell and the like which are used in outside.

The object of the invention is to solve the problem, and to provide a protective film comprising a plastic film and a coating layer and having high transparency, high ultraviolet absorption ability, high weatherability and flexibility, and its coating layers is not peeled from a plastic film even if the film is irradiated with ultraviolet. Furthermore, the invention relates to a front sheet for a solar cell using such a protective film.

Under the problem, the inventors have eagerly investigated and found that it is possible to provide a film attaining high adhesiveness between the plastic film and the coating layer, high transparency, high ultraviolet absorption ability, high weatherability and flexibility, by using cerium oxide particles as an inorganic series ultraviolet absorber and dispersing the cerium oxide particles using a surfactant comprising a Si-O bond and/or a Si-C bond, even if irradiated with ultraviolet. Thus, the inventors have completed the invention. Since cerium oxide particles are generally used as an abrading agent for glass and the like, it is remarkably amazing that such cerium oxide particles improve adhesiveness. Specifically, they have found that the above problems can be solved by the following means.

(1) A protective film comprising a plastic film and a coating layer on the surface of the plastic film, wherein the coating layer comprises a binder and cerium oxide particles dispersed in the binder, the cerium oxide particles are dispersed into the binder by using a surfactant comprising a Si-O bond and/or a Si-C bond, the content of the cerium oxide

particles in the coating layer is in a range of 10% by weight or more, the cerium oxide particles have an average particle size of 50 nm or less, and the binder has an average composition represented by the following formula (1); formula (1)

$$R^{11}_{m}Si(OR^{12})_{n}O_{(4-m-n)/2}$$

wherein $R^{11}$ is a methyl group, an ethyl group, or a phenyl group, $R^{12}$ is an alkyl group having carbon atoms of 1 to 8, $R^{11}$'s may be the same or different, $R^{12}$'s may be the same or different, and m and n satisfy $0.2 \leqq m \leqq 2$, $0.01 \leqq n \leqq 3$, and $m+n<4$.

(2) The protective film according to (1), wherein the cerium oxide particles have an average particle size of 30 nm or less.

(3) The protective film according to (1) or (2), wherein the coating layer comprises the cerium oxide particles in an amount of 10 to 45% by weight.

(4) The protective film according to any one of (1) to (3), wherein the plastic film comprises polycarbonate, polymethyl methacrylate or polyolefin.

(5) The protective film according to any one of (1) to (3), wherein the plastic film comprises polyethylene terephthalate.

(6) The protective film according to any one of (1) to (5), wherein the surfactant is an anionic surfactant or a cationic surfactant.

(7) The protective film according to any one of (1) to (6), wherein the cerium oxide particles have an average particle size of 3 nm or more.

(8) The protective film according to any one of (1) to (7), wherein the coating layer comprises the binder in an amount of 50 to 90% by weight and the cerium oxide particles in an amount of 10 to 45% by weight, and the cerium oxide particles have an average particle size of 3 to 50 nm.

(9) The protective film according to any one of (1) to (8), which comprises a barrier layer on the plastic film or the coating layer.

(10) The protective film according to any one of (1) to (8), which comprises a barrier layer on the plastic film.

(11) The protective film according to any one of (9) or (10), wherein the barrier layer comprises at least one organic layer and at least one inorganic layer.

(12) The protective film according to any one of (1) to (11), which has an absorbance of 3 or more at a wavelength of 330 nm.

(13) The protective film according to any one of (1) to (12), which has a haze of 5% or less.

(14) The protective film according to any one of (1) to (13), wherein the coating layer comprises a curing catalyst.

(15) The protective film according to any one of (1) to (14), wherein the surfactant comprises a group represented by the following formula;

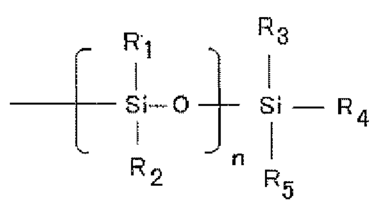

wherein $R_1$, $R_2$, $R_3$, $R_4$ and $R_5$ each are a group selected from an alkyl group having carbon atoms of 1 to 10 and an alkoxy group having carbon atoms of 1 to 10; n is an integer satisfying $0 \leqq n \leqq 30$; and when n is 2 or more, $R^1$'s and $R^2$'s each may be the same or different.

(16) The protective film according to any one of (1) to (15), wherein the coating layer has a thickness of 1 to 50μm.

(17) The protective film according to any one of (1) to (16), wherein the binder has a weight-average molecular weight (Mw) of 1000 to 10000.

(18) The protective film according to any one of (1) to (17), wherein the plastic film has a thickness of 1 to 1000 μm.

(19) The protective film according to any one of (1) to (18), wherein the cerium oxide particles have an average particle size of 5 to 25 nm.

(20) A front sheet for a solar cell, comprising a protective film according any one of (1) to (19).

The invention made it possible to provide a protective film having high transparency, high ultraviolet absorption ability, high weatherability and flexibility and being capable of maintaining high adhesiveness between each layers of the laminate film even if irradiated with ultraviolet.

BRIEF DESCRIPTION OF THE DRAWING

Fig. 1 shows a diagrammatic illustration showing a layer structure of the protective film comprising a barrier layer formed in Examples of the application, wherein 1 shows a plastic film, 2 shows an organic layer, 3 shows an inorganic layer, 4 shows a barrier layer and 5 shows a coating layer.

DESCRIPTION OF SPECIFIC EMBODIMENTS

The contents of the invention are described in detail hereinunder. In this description, the numerical range expressed by the wording "a number to another number" means the range that falls between the former number indicating the lowermost limit of the range and the latter number indicating the uppermost limit thereof.

The protective film of the invention comprises a plastic film and a coating layer on the surface of the plastic film, wherein the coating layer comprises a binder and cerium oxide particles dispersed in the binder, the cerium oxide is dispersed into the binder by using a surfactant comprising a Si-O bond and/or a Si-C bond, the coating layer comprises the cerium oxide in an amount of 10% by weight or more, the cerium oxide has an average particle size of 50 nm or less, and the binder has an average composition represented by the following formula (1);
formula (1)

$$R^{11}_mSi(OR^{12})_nO_{(4-m-n)/2}$$

wherein $R^{11}$ is a methyl group, an ethyl group, or a phenyl group, $R^{12}$ is an alkyl group having carbon atoms of 1 to 8, $R^{11}$'s may be the same or different, $R^{12}$'s may be the same or different, and m and n satisfy $0.2 \leqq m \leqq 2$, $0.01 \leqq n \leqq 3$, and $m+n<4$.

$R^{11}$ is a methyl group, an ethyl group, or a phenyl group, preferably a methyl group and/or an ethyl group. $R^{12}$ is preferably a methyl group and/or an ethyl group. One or more kinds of $R^{11}$'s and $R^{21}$'s each may be included.

Furthermore, m and n each satisfy $0.2 \leqq m \leqq 1$ and $0.1 \leqq n \leqq 2$ is preferable. The average composition means herein a composition specified according to a measured result of NMR(nuclear magnetic resonance spectrum), and/or according to a measured result of GPC(gel permeation chromatography) using polystyrene as a standard substance.

The weight-average molecular weight (Mw) of the binder used in the invention is preferably 1000 to 10000.

By using such a constitution, its high adhesiveness between the plastic film and the coating layer is attained, and its high transparency, high ultraviolet absorption ability, high weatherability and flexibility can be attained even if the film is irradiated with ultraviolet. Particularly, since zinc oxide has photo solubility, it has not been suitable to a protective film of a solar cell and the like which are placed in the condition where light is irradiated over long years. However, concerning cerium oxide, there is not such a problem since cerium oxide doesn't have photo solubility.

The plastic film used in the invention is not specifically limited without diverting the scope of the invention, and is preferably polycarbonate, polymethyl methacrylate, or polyolefin, more preferably polyethylene terephthalate. By employing such a resin, a film having high weatherability can be obtained at low cost.

The thickness of the plastic film is not specifically limited, and is preferably 1 to 1000 $\mu$m, more preferably 5 to 200 $\mu$m.

The cerium oxide used in the invention has an average particle size of 50 nm or less, preferably 3 to 40 nm, further more preferably 5 to 25 nm. By setting to such a range and dispersing the cerium oxide into the binder, the obtained film has higher transparency.

The coating layer preferably comprises cerium oxide in an amount of 10% by weight or more, more preferably comprises in an amount of from 10 to 45% by weight. By setting to such a range, the film having higher ultraviolet absorption ability can be obtained without losing its transparency.

The coating layer preferably comprises the above binder in an amount of 90% by weight or less, more preferably in an amount of from 90% by weight to 50% by weight. By setting to such a range, higher adhesiveness between the plastic film and the coating layer can be attained.

The thickness of the coating layer is not specifically defined, and is preferably 1 to 50$\mu$m, more preferably 1.5 to 20$\mu$m.

One or more kinds of the binders in the invention may be contained in the coating layer.

In addition, a curing catalyst may be added into the coating layer in order to accelerate a condensation reaction of the binder and to cure a coating layer. Examples of such a curing catalyst include metal salts of carbonic acid such as alkyl titanate, tin octylate, dibutyltin dilaurate, and dioctyltin dimalate; amine salts such as dibutyl amine-2-hexoate, dimethyl amine acetate, and ethanolamine acetate; quaternary ammonium salts of carboxylic acid such as tetramethylammonium acetate; amines such as tetra ethyl pentamine; amine series silane coupling agents such as N-β-aminoethyl-γ-aminopropyl trimethoxysilane, and N-β-aminoethyl-γ-aminopropyl methyl dimethoxy silane; acids such as p-toluenesulfonic acid, phthalic acid, and hydrochloric acid; aluminium compounds such as aluminium alkoxide, and aluminium

chelate; alkali series catalysts such as potassium hydroxide, titanium compounds such as tetraisopropyl titanate, tetrabutyl titanate, and titanium tetra acetyl acetate; halogenated silane such as methyltrichlorosilane, dimethyl dichloro silane, and trimethyl monochloro silane, and the like. Other compounds which are effective to the curing reaction of the binder may be used without limitations.

The amount of the curing catalyst to be added is preferably 0.001 to 20 parts by weight, relative to 100 parts weight of the binder component, more preferably 0.005 to 10 parts by weight, relative to 100 parts weight of the binder component. When the amount of the curing catalyst to be added is less than 0.001 parts by weight, the binder may sometimes not cure at a room temperature. When the amount of the curing catalyst to be added is more than 20 parts by weight, the coating layer may sometimes deteriorate in heat resistance or weatherability.

(Surfactant Comprising Si-O bond and/or Si-C bond)

In the invention, a surfactant comprising a Si-O bond and/or a Si-C bond is used for dispersing cerium oxide into the above binder. It is considered that use of such a surfactant comprising a similar structure to that of the binder component used in the invention enhances affinity between a diluting solvent used for the coating solution and the above binder, to thereby be able to maintain dispersibility of the cerium oxide in the dried layer after the coating solution is coated and dried.

The ionic surfactant is preferably an anionic surfactant having a group represented by the following formula, such as hydrosulfates, phosphates, carboxylate salts and a cationic surfactant having a group represented by the following formula, such as quaternary ammonium salts;

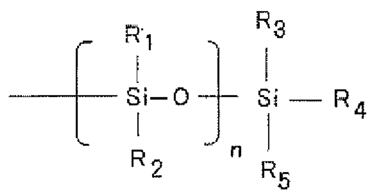

wherein $R_1$, $R_2$, $R_3$, $R_4$ and $R_5$ each are a group selected from an alkyl group having carbon atoms of 1 to 10 and an alkoxy group having carbon atoms of 1 to 10; n is an integer satisfying $0 \leqq n \leqq 30$; and when n is 2 or more, $R^{1}$' s and $R^{2}$'s each may be the same or different.

Examples thereof include 2-(trimethylsilyl) sodium ethanesulfonate and 2-(trimethylsilyl) sodium propane sulfonate.

In the invention, the cerium oxide is dispersed into a diluting solution using the above surfactant, and the cerium oxide-containing dispersion is dispersed into the binder. Such means can further enhance the dispersibility of the cerium oxide into the binder, and makes it possible to suppress brown discoloration which is caused by exposing ultraviolet to the surfactant.

It is also possible to carry out the dispersion by a mechanical dispersion method in addition to the method using the above dispersant. In such a case, the dispersion may be carried out by using general mixing apparatus such as sand mill, ball mill, and paint shaker.

The protective film of the invention may have various functional layers on the plastic film or the coating layer without diverting the scope of the invention. Examples of the functional layer include a matting agent layer, a protective layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, a barrier layer, etc.

In the protective film, the barrier layer may be disposed on the plastic film or the coating layer, preferably on the plastic layer. The barrier layer may be provided on the surface of the plastic layer or be provided on the plastic layer through another functional layer.

The barrier layer preferably comprises at least one organic layer and at least one inorganic layer, and may comprise two or more organic layers and two or more inorganic layers laminated alternately. The organic layer may be applied to the technique disclosed in JP-A- 2009-081123, paragraphs from 0026 to 0052. The inorganic layer may be applied to the technique disclosed in JP-A-2009-081123, paragraphs 0024 and 0025.

The absorbance of the protective film of the invention may be 3 or more at wavelength of 330 nm, and may be further 3.5 or more at wavelength of 330 nm.

The haze of the protective film of the invention may be controlled to be 5% or less, further may be controlled to be 4.5% or less, and may be particularly to be controlled to 3% or less.

The protective film of the invention can be used for various applications, preferably a protective member of a sheet used for a solar cell, particularly preferably of a protective member of a front sheet used for a solar cell.

(Solar Cell)

The protective film of the invention can be used as a protective member of a sheet used for a solar cell. Solar cells generally have a construction wherein an active part which practically operates as a solar cell is disposed between a pair of substrates. The protective film of the invention may be used as a protective member for one or both of the pair of substrates, preferably is used as a protective member for a front sheet for a solar cell. In addition, the protective film itself may be used as a sheet for a solar cell.

The solar cell devices for which the protective film of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

EXAMPLES

The characteristics of the invention are described more concretely with reference to the following Examples. In the following Examples, the material used, its amount and the ratio, the details of the treatment and the treatment process may be suitably modified or changed not overstepping the sprit and the scope of the invention. Accordingly, the invention should not be limitatively interpreted by the Examples mentioned below.

1. Formation of Protective Films

Example 1

(Preparation of Binder Composition)

A silicone alkoxide series binder composition was prepared by mixing 100 parts by weight of alkoxy silicon oligomer as a siloxane series binder (manufactured by Shin-Etsu Chemical Co., Ltd., X-40-9250), 5 parts by weight of titanium series curing catalyst (manufactured by Shin-Etsu Chemical Co., Ltd., D-20) and 100 parts by weight of butanol.

(Preparation of Cerium-containing Butanol Dispersion Liquid)

30 parts by weight of Needral U-15 (manufactured by Taki Chemical Co., Ltd.; the average particle size is 10 nm, the content of $CeO_2$ is 15% by weight) was diluted with 90 parts by weight of water. To this, 180 parts by weight of aqueous solution of 2-(trimethylsilyl) sodium ethanesulfonate (manufactured by ALDRICH) as a surfactant in the concentration of 1% by weight was added, to thereby obtain deposition. The deposition was filtrated and washed, to thereby obtain wet cake. This wet cake was re-dispersed into 1-Butanol, to thereby obtain a $CeO_2$ particle-containing butanol dispersion liquid.

(Preparation of Coating Composition)

To the above binder composition, the above $CeO_2$ particle-dispersion liquid was added so that the solid content of $CeO_2$ particles in the coating layer was controlled to be 30% by weight, and stirred to thereby obtain a coating solution.

(Formation of Protective Film and Sample for Tests)

On a polyethylene terephthalate film (manufactured by Fujifilm Corporation, FQ125), the above coating composition was coated so as to have a thickness of 5μm, and then dried for 6 hours at room temperature, to thereby obtain a protective film.

For measuring ultraviolet absorption and ultraviolet absorption retention, the above coating composition was

coated so as to have a thickness of 5μm on a glass substrate, and then dried for 6 hours at room temperature, to thereby obtain a sample for the tests.

Example 2 (Change of Kinds of Surfactant)

A protective film and a sample for the tests were obtained according to the same method as that in Example 1, except that 2-(trimethylsilyl) sodium ethanesulfonate as a surfactant was replaced with 2-(trimethylsilyl) sodium propane sulfonate. Comparative Example 1 (Formation of Protective Film Using ZnO Particles Having an Average Particle Size of 4 nm Instead of $CeO_2$ Particles)

(Preparation of Coating Composition)

To 65 parts by weight of zincacetatedihydrate, 150 parts by weight of methanol was added, to thereby obtain a clouded solution. To this, 150 parts by weight of octylamine was added and stirred for 20 minutes, to thereby obtain a clear solution. To this, 30 parts by weight of potassiumhydrate dissolved in 100 parts by weight of methanol was added, to thereby obtain a clouded solution again. Then, the solution was centrifuged at 4000 rpm for 30 minutes followed by removing its supernatant, which was repeated three times, to thereby obtain white powder. To this, 200 parts by weight of 1-butanol was added, to thereby obtain zinc oxide nano particles-butanol dispersion liquid. The obtained zinc oxide particles were ZnO particles having an average particle size of 4 nm. The above ZnO particles-butanol dispersion liquid was added to the binder composition prepared in Example 1 so that the solid content of ZnO particles was controlled to be 30% by weight, relative to the binder composition, and stirred to thereby obtain a coating composition.

(Formation of Protective Film and Sample for Tests)

A protective film and sample for the tests were obtained according to the same method as that in Example 1, except that the coating composition was replaced with the above.

Comparative Example 2 (Formation of Coating Layer Disclosed in JP-A-2000-334373)

100 parts by weight of methyl trimethoxy silane, 20 parts by weight of tetramethoxy silane, 150 parts by weight of isopropylalcoholorgano silica sol (manufactured by JGC Catalysts and Chemicals Ltd., OSCAL1432, the content of $SiO_2$ is 30% by weight), 40 parts by weight of dimethyl dimethoxy silane and 100 parts by weight of isopropyl alcohol were mixed, and then, 200 parts by weight of water was added and further stirred. This was controlled to have a weight-average molecular weight (Mw) of 1200 in a thermostatic bath at 60˚C, to thereby obtain a silicon alkoxide series coating composition.

To 50 parts by weight of methyltrimethoxysilane, 40 parts by weight of zinc oxide fine particles having an average particle size of 40 nm, 5 parts by weight of carbonic acid series dispersant and 5 parts by weight of diluting solvent were added and stirred with a disper for 30 minutes, and then, dispersed using glass beads having a size of 1 mm with a disperser (manufactured by WAB, DYNO-Mill, the flow rate is 25 kg/hr, the vessel bulk is 1.5 1, repeated five times), to thereby obtain zinc oxide fine particles mill base.

The mill base for zinc oxide fine particle was add to have a concentration of 15% by weight of the zinc oxide fine particles having an average particle size of 40 nm to the above silicon alkoxide series coating composition. By the above method, the coating composition disclosed in JP-A-2000-334373 was prepared.

A protective film and a sample for the tests were obtained according to the same method as that in Example 1, except that the coating composition was replaced with the above coating composition.

Comparative Example 3 (Comparative Example using cerium oxide having an average particle of 220 nm)

(Preparation of Cerium Oxide Particle-Containing Butanol Dispersion Liquid)

A cerium oxide particle-containing butanol dispersion liquid was obtained by adding 100 parts by weight of butanol and 50 parts by weight of X-40-9250 to 10 parts by weight of cerium oxide particles(manufactured by Showa Denko K.K., GPL grade, C1010, the average particle size is 220 nm) and dispersing it with a planetary ball mill.

(Preparation of Coating Composition)

A cerium oxide particle-containing butanol dispersion liquid was added to the above binder composition so that the solid content of $CeO_2$ particles was controlled to be 30% by weight, relative to the coating layer, and stirred, to

thereby obtain a coating composition.

(Formation for Protective Film and Sample for Tests)

A protective film and a sample for the tests were obtained according to the same method as that in Example 1, except that the coating composition was replaced with the above coating composition.

Comparative Example 4 (Comparative Example Using 9% by Weight of Cerium Oxide)

A protective film and a sample for the tests were obtained according to the same method as that in Example 1, except that the solid content of cerium oxide particles is controlled to be 9% by weight.

Comparative Example 5

(Formation of Complex of Siloxane Component and Cerium Nano Particle disclosed in JP-A 2002-371234)

(Preparation of Binder Composition)

55 parts by weight of methyl methacrylate, 5 parts by weight of 2-ethylhexyl acrylate, 5 parts by weight of cyclohexyl methacrylate, 10 parts by weight of $\gamma$ -methacryloxy propyl trimethoxysilane, 20 parts by weight of glycidyl methacrylate, 5 parts by weight of 4-(meth)acryloyloxy-2,2,6,6-tetramethylpiperidine, 75 parts by weight of i-buthyl alcohol, 50 parts by weight of methylethylketone, and 25 parts by weight of methanol were mixed, and then, stirred and heated up to 80° C. To this mixture, a solution of 3 parts by weight of azobis isobutyronitrile in 8 parts by weight of xylene was incrementally dropped for 30 minutes, and then, reacted at 80° C for 5 hours. Then, to this, 36 parts by weight of methylethylketone was added and stirred, to thereby prepare a solution of polymer having Mw of 12, 000 in the solid concentration of around 35%.

118 parts by weight of the polymer solution, 24 parts by weight of methyltrimethoxysilane, 10 parts by weight of dimethyldimethoxysilane, 2 parts by weight of di-i-propoxyethyl acetate aluminium and 10 parts by weight of i-propylalcohol were mixed, and stirred and heated up to 50° C. To this, 6 parts by weight of water was incrementally added for 30 minutes and reacted at 60° C for 4 hours. Then, to this, 2 parts by weight of acetylacetone was added and stirred for 1 hour, and then, cooled to a room temperature. 40 parts by weight of methyl isobutylketone as a diluent solution was added under being stirred, to thereby prepare a binder composition corresponding to a under coating composition disclosed in JP-A-2002-371234.

(Preparation of Coating Composition)

A coating composition was prepared by adding the $CeO_2$ particles butanol dispersion liquid in Example 1 into the above binder composition so that the solid concentration of $CeO_2$ particles is 30% by weight, relative to the coating layer and stirring it.

(Formation of Protective Film and Sample for Tests)

A protective film and a sample for the tests were obtained according to the same method as that in Example 1, except that the coating composition was replaced with the above coating composition.

Comparative Example 6 (Use of Surfactant other than Si Series Surfactant)

A protect film and sample for the tests were obtained according to the same method as that in Example 1, except that 2-(trimethylsilyl) sodium ethanesulfonate as a surfactant was replaced with sodium dodecylbenzenesulfonate.

Comparative Example 7 (Comparative Example using PVA as a binder)

(Preparation of Binder Composition)

A binder composition was prepared by mixing 2 parts by weight of polyvinylalcohol "PVA-117" (manufactured by kuraray Co. , Ltd.), as a binder, and 98 parts by weight of water.

(Preparation of Coating Composition)

A coating composition was prepared by adding Needlal U-15 (manufactured by Taki Chemical Co. , Ltd.; the particle average size is 10 nm, the content of $CeO_2$ is 15% by weight) so as to have a solid concentration of $CeO_2$ particles of 30% by weight, relative to the coating layer and stirring it.

(Formation of Protective Film and Sample for Tests)

A protective film and a sample for the tests were obtained according to the same method as that in Example 1, except that the coating composition was replaced with the above coating composition.

Comparative Example 8 (Comparative Example using titanium oxide particles)

A protective film and a sample for the tests were obtained according to the same method as that in Example 1, except that Needlal U-15 was replaced with Tynoc AM-15 (manufactured by Taki Chemical Co. , Ltd. ; the average particle size of 20 nm, the content of $TiO_2$ is 15% by weight).

Example 3 (Change of Kind of Binder)

A protective film and a sample for the tests were obtained according to the same method as that in Example 1, except that the siloxane series binder X-40-9250 was replaced with a binder composition composed of 80 parts by weight of X-40-9250 and 20 parts by weight of KR-500 (manufactured by Shin-Etsu Chemical Co., Ltd.) in the preparation of a binder composition.

Example 4 (Change of Kind of Binder)

A protective film and a sample for the tests were obtained according to the same method as that in Example 1, except that the siloxane series binder X-40-9250 was replaced with a binder composition composed of 80 parts by weight of X-40-9250, 10 parts by weight of X-40-9225 (manufactured by Shin-Etsu Chemical Co., Ltd.) and 10 parts by weight of KR-500 in the preparation of a binder composition.

Example 5 (Change of Kind of Plastic Film)

A protective film and a sample for the tests were obtained according to the same method as that in Example 1, except that the polyethylene terephthalate film was replaced with a polymethylmethacrylate film (manufactured by Sumitomo Chemical Co. Ltd., technolloy S001, having a thickness of 75 $\mu$m).

Example 6 (Change of Kind of Plastic Film)

A protective film and a sample for the tests were obtained according to the same method as that in Example 1, except that the polyethylene terephthalate film was replaced with a polycarbonate film (manufactured by Teijin Chemicals Ltd., Pure-Ace, having a thickness of 100$\mu$m).
For the obtained protective films and samples for the test, the following evaluations were carried out.

(Haze Measurement)

According to JIS K7361 and JIS K7361-1, haze for each of the protective films was measured using a haze meter (manufactured by Nippon Denshioku Industries Co., Ltd., NDH 5000).

(Optical Transmittance)

Optical transmittance of each of the protective films was measured according to JIS R3106.

(Absorbance)

Absorbance spectrum at 330 nm for each of the samples for the tests was measured using an ultraviolet-visible spectralphotometer (manufactured by JASCO Corporation, V-560).
The absorbance spectrum was measured for the samples for the test instead of the protective films of the

invention because a plastic film which is used in the protective film in Examples may not be correctly measured for its absorbance spectrum according to this measuring method. The reason is that ultraviolet absorption capacity of a protective layer such as that in Comparative Example 1 reduces by ultraviolet exposure, and a plastic film which is the underlayer of such a protective layer deteriorates and turns yellow after the ultraviolet expose, so that the absorbance for the protective layer itself may not be correctly measured. However, it was confirmed that absorbance value measured for the samples for the tests shows a similar tendency to that for the corresponding protective film. This is because the clear and colorless PET film of which the protective layer protects from ultraviolet and suppresses its deterioration has very little absorbance at 330 nm. Thus, each of the samples for the test shows absorbance of the corresponding protective film.

(Ultraviolet Absorbance Retention)

Ultraviolet exposure test to the samples for the tests was carried at 0.53 kW/m$^2$ (wavelength was 300 to 400 nm) for 1000 hours using a Metaling Vertical Weather Meter (manufactured by Suga Test Instruments Co., Ltd., MV3000). The test was carried out under the following condition;
black panel temperature was 63˚C, and
humidity in a basin was 50%.
Absorbance at 330 nm before and after the above ultraviolet exposure test was measured using an ultraviolet-visible spectralphotometer (manufactured by JASCO Corporation, V-560). The results are shown according to the following formula;

ultraviolet absorbance retention (%) =
(absorbance at 330 nm after ultraviolet exposure test)/
(absorbance at 330 nm before ultraviolet exposure test) *100

(External Observation)

The protective films after the ultraviolet expose were visually observed.

(Flexibility Evaluation According to Bending Test)

Bending test was carried out according the following method. The protective film of which the above ultraviolet exposure test was carried out was cut into 10 cm × 10 cm, the edges of the protective film were stuck to form cylindrical shape so that the coating layer becomes outside. The cylindrical shape-protective film was put between two transfer rollers having a diameter of 12 mm at a tension of about 1 N, and was transferred as it was turned around at 30 cm/min with careful attention to keep complete contact between the laminate film and the roller and not to slide the laminate film. After that, visual observation of crack which occurs on the protective film was carried out.
○ : crack did not occur.
×: crack occurred.

(Adhesion after Bending Test)

After the above bending test, adhesion of a protective film was tested in a cross-cut peeling test according to JIS K5400. The surface of the protective film was cut with a cutter knife at an angle of 90˚ to the film surface, at intervals of 1 mm, thereby forming 100 cross cuts at intervals of 1 mm. A 2 cm wide Mylar Tape (manufactured by Nitto Denko Corporation, polyester tape No. 31B) was stuck to it, and using a tape peeling tester, the tape was peeled off. Of the 100 cross cuts on the surface of the sample, the number (n) of the cross cuts having remained on the surface of the sample without being peeled away was counted. The results are shown the table below.

[Table 1]

| | Haze Measurement (%) | Optical Transmittance (%) | Ultraviolet Absorbance Retention (%) | Absorbance | Flexibility Evacuation According to Bending Test | Adhesion after Bending Test (n /100) | External Observation |
|---|---|---|---|---|---|---|---|
| Example 1 | 1 | 92.5 | 99.5 | 3.3 | ○ | 98 | Transparency |
| Example 2 | 1.3 | 91.5 | 99.1 | 3.2 | ○ | 95 | Transparency |
| Example 3 | 1.1 | 92 | 99.3 | 3.2 | ○ | 97 | Transparency |
| Example 4 | 1.2 | 92.4 | 99.1 | 3.2 | ○ | 95 | Transparency |
| Example 5 | 1 | 92.3 | 99.1 | 3.3 | ○ | 86 | Transparency |
| Example 6 | 1 | 91.3 | 99.2 | 3.3 | ○ | 84 | Transparency |
| Comp. Exam. 1 | 0.7 | 92.9 | 5 | 2.5 | × | 0 | Yellow Turbidity |
| Comp. Exam. 2 | 15.3 | 84.3 | 90.1 | 2.2 | × | 4 | White Turbidity |
| Comp. Exam. 3 | 25.5 | 81.5 | 99.1 | 3.1 | ○ | 94 | White Turbidity |
| Comp. Exam. 4 | 1 | 89.5 | 99.2 | 2.2 | × | 6 | Yellow Turbidity |
| Comp. Exam. 5 | 4.8 | 87.2 | 98.2 | 3 | × | 5 | Transparency |
| Comp. Exam. 6 | 1.6 | 90.2 | 99.1 | 3 | × | 12 | Brown Discoloration |
| Comp. Exam. 7 | 1.1 | 87.6 | 99 | 3.1 | × | 0 | Transparency |
| Comp. Exam. 8 | 19.7 | 80.2 | 99.1 | 3.2 | × | 3 | White Turbidity |

2. Protective Film Having Barrier Layer

A protective film having a layer structure shown in Fig. 1 was formed. On a surface of a polyethylene terephthalate film (manufactured by Toray Industries, Inc., T60), an organic layer 2 and an inorganic layer 3 were formed according to the same method as that of Sample 101 in Example in JP-A-2009-081123, thereby forming a barrier layer 4. According to the same method as that in Example 1, a coating layer 5 was formed on the surface at the side opposite to the side at which the barrier layer of the film was deposited.

3. Formation of Front Sheet for Solar Cell

The protective film having the barrier layer in the above Example and the CIS series thin film solar cell described in Example 1 in JP-A-2009-99973 were stuck using ethylene vinyl acetate (EVA) resin film as an adhesive, thereby forming a solar cell. It was confirmed that the solar cell is operative.

## Claims

1. A protective film comprising a plastic film and a coating layer on the surface of the plastic film, wherein the coating layer comprises a binder and cerium oxide particles dispersed in the binder, the cerium oxide particles are dispersed into the binder by using a surfactant comprising a Si-O bond and/or a Si-C bond, the content of the cerium oxide particles in the coating layer is in a range of 10% by weight or more, the cerium oxide particles have an average particle size of 50 nm or less, and the binder has an average composition represented by the following formula (1); formula (1)

$$R^{11}_{m}Si(OR^{12})_{n}O_{(4-m-n)/2}$$

wherein $R^{11}$ is a methyl group, an ethyl group, or a phenyl group, $R^{12}$ is an alkyl group having carbon atoms of 1 to 8, $R^{11}$'s may be the same or different, $R^{12}$'s may be the same or different, and m and n satisfy $0.2 \leqq m \leqq 2$, $0.01 \leqq n \leqq 3$, and $m+n<4$.

2. The protective film according to Claim 1, wherein the cerium oxide particles have an average particle size of 30 nm or less.

3. The protective film according to Claim 1 or 2, wherein the coating layer comprises the cerium oxide particles in an amount of 10 to 45% by weight.

4. The protective film according to any one of Claims 1 to 3, wherein the plastic film comprises polycarbonate, polymethyl methacrylate or polyolefin.

5. The protective film according to any one of Claims 1 to 3, wherein the plastic film comprises polyethylene terephthalate.

6. The protective film according to any one of Claims 1 to 5, wherein the surfactant is an anionic surfactant or a cationic surfactant.

7. The protective film according to any one of Claims 1 to 6, wherein the cerium oxide particles have an average particle size of 3 nm or more.

8. The protective film according to any one of Claims 1 to 7, wherein the coating layer comprises the binder in an amount of 50 to 90% by weight and the cerium oxide particles in an amount of 10 to 45% by weight, and the cerium oxide particles have an average particle size of 3 to 50 nm.

9. The protective film according to any one of Claims 1 to 8, which comprises a barrier layer on the plastic film or the coating layer.

10. The protective film according to any one of Claims 1 to 8, which comprises a barrier layer on the plastic film.

11. The protective film according to Claim 9 or 10, wherein the barrier layer comprises at least one organic layer and

at least one inorganic layer.

**12.** The protective film according to any one of Claims 1 to 11, which has an absorbance of 3 or more at a wavelength of 330 nm.

**13.** The protective film according to any one of Claims 1 to 12, which has a haze of 5% or less.

**14.** The protective film according to any one of Claims 1 to 13, wherein the coating layer comprises a curing catalyst.

**15.** A front sheet for a solar cell, comprising the protective film according to any one of Claims 1 to 14.

Fig. 1

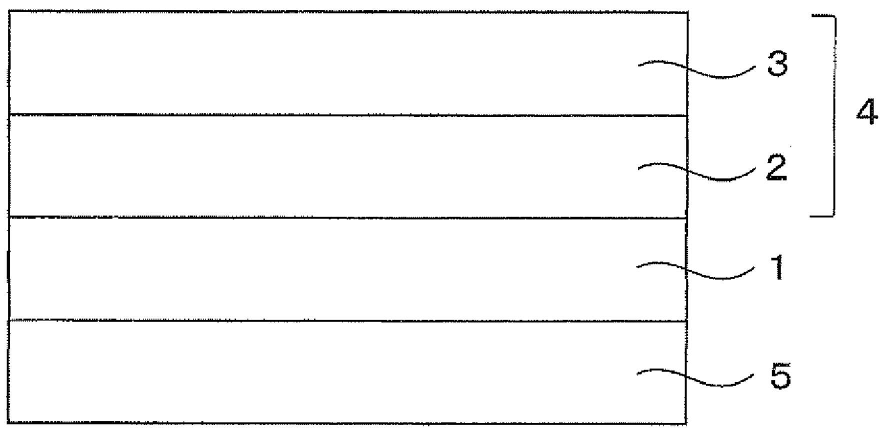

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006255927 A
- JP 2004168057 A
- JP 2000334373 A
- JP 2002371234 A
- JP 2009081123 A
- JP 2009099973 A